# EUROPÄISCHE PATENTANMELDUNG

(11) **EP 4 293 847 A1**
(43) Veröffentlichungstag der Anmeldung: **20.12.2023**
(21) Anmeldenummer: 23178954.6
(22) Anmeldetag: 13.06.2023
(51) Int. Cl.: H02H 3/04, G01R 31/27, G01R 31/327, H03K 17/18, G01R 31/26

(54) **VERFAHREN ZUM BETRIEB EINER ELEKTRISCHEN SCHALTEINRICHTUNG UND ELEKTRISCHE SCHALTEINRICHTUNG**

(30) Priorität: 13.06.2022 DE 102022114830
(71) Anmelder: Yazaki Systems Technologies GmbH, 93059 Regensburg (DE)
(72) Erfinder: FRADCZYK, Rafael, 93105 Tegernheim (DE); CHAU, Thanh Qui, 93105 Tegernheim (DE)
(74) Vertreter: Patentanwaltskanzlei WILHELM & BECK

(57) **Zusammenfassung**

Die Erfindung betrifft ein Verfahren zum Betrieb einer elektrischen Schutzeinrichtung (10) mit einem Feldeffekttransistor (20) zur elektrischen Absicherung eines elektrischen Verbrauchers (40), vorzugsweise in einem Kraftfahrzeug, und eine elektrische Schutzeinrichtung (10), wobei der Feldeffekttransistor (20) einen Gate-Anschluss (80), einen Source-Anschluss (75) und einen Drain-Anschluss (85) aufweist, wobei wenigstens ein Prüfsignal mit wenigstens einer vordefinierten Prüfspannung und mit wenigstens einer vordefinierten ersten Prüffrequenz zwischen dem Gate-Anschluss (80) des Feldeffekttransistors (20) und dem Source-Anschluss (75) angelegt wird, wobei wenigstens ein über einen der Anschlüsse (75, 80, 85) auf Grundlage des Prüfsignals fließender Strom (I_{DS}, I_{G}) ermittelt wird, wobei eine Spannung (U_{DS}, U_{GS}) zwischen dem Source-Anschluss (75) und dem Drain-Anschluss (85) und/oder zwischen dem Source-Anschluss (75) und dem Gate-Anschluss (80) ermittelt wird, wobei auf Grundlage der ermittelten Spannung (U_{DS}, U_{GS}) und des ermittelten Stroms (I_{DS}, I_{G}) eine Gesamtimpedanz (R) des Feldeffekttransistors (20) ermittelt wird, wobei auf Grundlage einer ursprünglichen Impedanz (Ru) des Feldeffekttransistors (20) und der ermittelten Gesamtimpedanz (R) ein Transistorzustand (G) des Feldeffekttransistors (20) ermittelt wird.

## Beschreibung

Die Erfindung betrifft ein Verfahren gemäß Patentanspruch 1 und eine elektrische Schutzeinrichtung gemäß Patentanspruch 11.

Aus der DE 11 2004 002 301 T5 ist eine elektrische Schutzeinrichtung bekannt.

Es ist Aufgabe der Erfindung, ein verbessertes Verfahren zum Betrieb einer elektrischen Schutzeinrichtung und eine verbesserte Schutzeinrichtung bereitzustellen.

Diese Aufgabe wird mittels eines Verfahrens gemäß Patentanspruch 1 und mittels einer elektrischen Schutzeinrichtung gemäß Patentanspruch 11 gelöst. Vorteilhafte Ausführungsformen sind in den abhängigen Ansprüchen angegeben.

Es wurde erkannt, dass ein verbessertes Verfahren zum Betrieb einer elektrischen Schutzeinrichtung zur elektrischen Absicherung eines elektrischen Verbrauchers, vorzugsweise in einem Kraftfahrzeug, und eine verbesserte Schutzeinrichtung dadurch bereitgestellt werden können, dass die Schutzeinrichtung einen Feldeffekttransistor aufweist. Der Feldeffekttransistor weist einen Gate-Anschluss, einen Source-Anschluss und einen Drain-Anschluss auf. Es wird wenigstens ein Prüfsignal mit wenigstens einer vordefinierten Prüfspannung und mit wenigstens einer vordefinierten ersten Prüffrequenz zwischen dem Gate-Anschluss des Feldeffekttransistors und dem Source-Anschluss angelegt. Es wird wenigstens ein über einen der Anschlüsse auf Grundlage des Prüfsignals fließender Strom ermittelt. Weiter wird eine Spannung zwischen dem Source-Anschluss und dem Drain-Anschluss und/oder zwischen dem Source-Anschluss und dem Gate-Anschluss ermittelt. Außerdem wird auf Grundlage der ermittelten Spannung und des ermittelten Stroms eine Gesamtimpedanz des Feldeffekttransistors ermittelt. Ferner wird auf Grundlage der einer ursprünglichen Impedanz des Feldeffekttransistors und der ermittelten Gesamtimpedanz ein Transistorzustand des Feldeffekttransistors ermittelt.

Diese Ausgestaltung hat den Vorteil, dass durch die Überprüfung des Transistorzustands des Feldeffekttransistors zuverlässig eine elektrische Isolierwirkung des Feldeffekttransistors in getrenntem Zustand überprüft werden kann, so dass sichergestellt ist, dass der Feldeffekttransistor funktionsfähig ist und in geöffnetem Zustand zuverlässig den Verbraucher von einer elektrischen Energiequelle abtrennt.

In einer weiteren Ausführungsform wird der ermittelte Transistorzustand mit einem vordefinierten ersten Schwellenwert verglichen, wobei bei Überschreiten des ersten Schwellenwerts eine Warninformation ausgegeben wird. Diese Ausgestaltung hat den Vorteil, dass, bevor der Feldeffekttransistor ausfällt, der Nutzer oder ein Wartungspersonal im Rahmen einer Wartung der elektrischen Schutzeinrichtung über den zunehmend schlechter werdenden Transistorzustand informiert wird und dadurch die Möglichkeit gegeben wird, vorab vor Beschädigung und Ausfall der Feldeffekttransistor oder die elektrische Schutzeinrichtung zu tauschen.

In einer weiteren Ausführungsform wird der ermittelte Transistorzustand mit einem zweiten Schwellenwert verglichen, wobei der zweite Schwellenwert größer als der erste Schwellenwert ist. Bei einem Überschreiten des zweiten Schwellenwerts durch den ermittelten Transistorzustand wird eine Übertragung von elektrischer Leistung zwischen dem Drain-Anschluss und dem Source-Anschluss dauerhaft unterbrochen. Diese Ausgestaltung stellt sicher, dass mit dem beschädigten bzw. defekten Feldeffekttransistor die Schutzeinrichtung nicht weiter genutzt wird.

In einer weiteren Ausführungsform wird zur Ermittlung eines Impedanzspektrums des Feldeffekttransistors das Prüfsignal zwischen der ersten Prüffrequenz und einer zur ersten Prüffrequenz unterschiedlichen zweiten Prüffrequenz variiert. Jeweils der auf Grundlage des Prüfsignals fließende elektrische Strom und die elektrische Spannung zwischen dem Source-Anschluss und dem Drain-Anschluss und/oder zwischen dem Source-Anschluss und dem Gate-Anschluss werden ermittelt. Zu jeweils der Prüffrequenz des Prüfsignals wird auf Grundlage des ermittelten elektrischen Stroms und der ermittelten Spannung jeweils eine Impedanz zur Ermittlung des Impedanzspektrums ermittelt. Die Gesamtimpedanz wird auf Grundlage des Impedanzspektrums ermittelt. Diese Ausgestaltung hat den Vorteil, dass der Feldeffekttransistor besonders umfangreich geprüft wird.

In einer weiteren Ausführungsform wird die Gesamtimpedanz durch die Integration eines Verlaufs der Impedanz über der Frequenz zwischen der ersten Prüffrequenz und der zweiten Prüffrequenz ermittelt. Dies hat den Vorteil, dass die Gesamtimpedanz besonders einfach ermittelt werden kann.

In einer weiteren Ausführungsform wird auf Grundlage einer vordefinierten Ersatzschaltung des Feldeffekttransistors und des Impedanzspektrums ein induktiver Anteil des Feldeffekttransistors ermittelt, wobei auf Grundlage des ermittelten induktiven Anteils und eines vordefinierten induktiven ursprünglichen Anteils ein induktiver Gesamtzustand des Feldeffekttransistors ermittelt wird.

In einer weiteren Ausführungsform wird auf Grundlage einer vordefinierten Ersatzschaltung des Feldeffekttransistors und des ermittelten Impedanzspektrums ein kapazitiver Anteil des Feldeffekttransistors ermittelt, wobei auf Grundlage des ermittelten kapazitiven Anteils und eines vordefinierten kapazitiven ursprünglichen Anteils ein kapazitiver Gesamtzustand des Feldeffekttransistors ermittelt wird.

In einer weiteren Ausführungsform des Verfahrens wird auf Grundlage einer vordefinierten Ersatzschaltung des Feldeffekttransistors und des ermittelten Impedanzspektrums ein ohmscher Anteil des Feldeffekttransistors ermittelt, wobei auf Grundlage des ermittelten ohmschen Anteils und eines vordefinierten ohmschen ursprünglichen Anteils ein ohmscher Gesamtzustand ermittelt wird.

In einer weiteren Ausführungsform wird der Strom, der zu dem Gate-Anschluss des Feldeffekttransistors fließt, ermittelt. Die Spannung wird zwischen dem Source-Anschluss und dem Gate-Anschluss ermittelt. Diese Ausgestaltung hat den Vorteil, dass die elektrische Schutzeinrichtung besonders einfach und kostengünstig aufgebaut ist.

In einer weiteren Ausführungsform wird der Strom, der zwischen dem Drain-Anschluss und dem Source-Anschluss fließt, ermittelt. Die Spannung wird zwischen dem Source-Anschluss und dem Drain-Anschluss ermittelt. Diese Ausgestaltung hat den Vorteil, dass der Feldeffekttransistor besonders gut überprüft wird.

Nachfolgend wird die Erfindung anhand von Figuren näher erläutert. Dabei zeigen:
- Figur 1: eine elektrische Schutzeinrichtung für ein Kraftfahrzeug gemäß einer ersten Ausführungsform;
- Figur 2: zeigt ein Ablaufdiagramm eines Verfahrens gemäß einer ersten Ausführungsform zur Überprüfung und Bewertung der in Figur 1 gezeigten elektrischen Schutzeinrichtung;
- Figur 3: zeigt ein Ablaufdiagramm eines Verfahrens gemäß einer zweiten Ausführungsform zur Überprüfung der in Figur 1 gezeigten Schutzeinrichtung;
- Figur 4: zeigt ein Diagramm eines ermittelten Impedanzverlaufs eines in Figur 1 gezeigten Feldeffekttransistors der in Figur 1 gezeigten Schutzeinrichtung;
- Figur 5: zeigt eine schematische Darstellung einer elektrischen Schutzeinrichtung gemäß einer zweiten Ausführungsform;
- Figur 6: ein Ablaufdiagramm eines Verfahrens gemäß einer dritten Ausführungsform zur Bewertung der in Figur 5 gezeigten elektrischen Schalteinrichtung;
- Figur 7: ein Ablaufdiagramm eines Verfahrens gemäß einer vieren Ausführungsform zur Bewertung der in Figur 5 gezeigten elektrischen Schalteinrichtung.

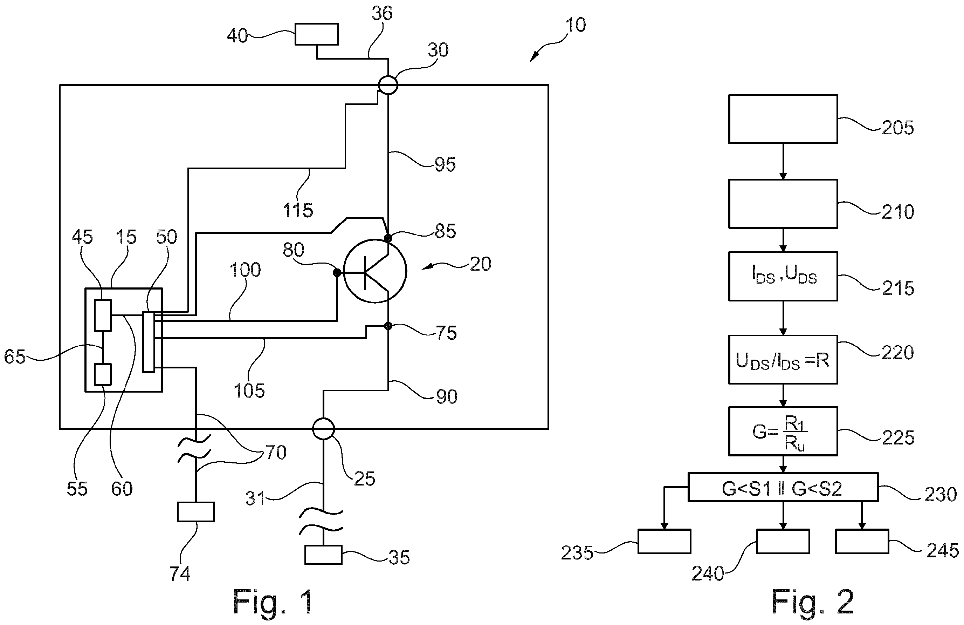

Figur 1 zeigt eine elektrische Schutzeinrichtung 10 für ein Kraftfahrzeug gemäß einer ersten Ausführungsform.

Die elektrische Schutzeinrichtung 10 weist ein Steuergerät 15 und einen Feldeffekttransistor 20 auf. Ferner weist die elektrische Schutzeinrichtung 10 einen ersten Anschluss 25 und einen zweiten Anschluss 30 auf.

Der erste Anschluss 25 kann beispielsweise mit einer elektrischen Energiequelle 35 des Kraftfahrzeugs mittels einer ersten elektrischen Verbindung 31 verbunden sein. Die elektrische Energiequelle 35 kann beispielsweise ein elektrischer Energiespeicher, beispielsweise eine Traktionsbatterie eines Elektrofahrzeugs oder eines Hybridfahrzeugs, oder ein Generator des Kraftfahrzeugs sein.

Der zweite Anschluss 30 kann beispielsweise mittels einer zweiten elektrischen Verbindung 36 mit einem elektrischen Verbraucher 40 elektrisch verbunden sein. Der elektrische Verbraucher 40 kann beispielsweise ein Antriebsmotor eines elektrischen Fensterhebers, eine Heckscheibenheizung, eine Beleuchtungsanlage des Kraftfahrzeugs und/oder ein Kraftfahrzeugsteuergerät des Kraftfahrzeugs sein.

Das Steuergerät 15 weist eine Steuereinrichtung 45, eine Schnittstelle 50 und einen Datenspeicher 55 auf. Die Schnittstelle 50 ist mittels einer ersten Datenverbindung 60 mit der Steuereinrichtung 45 datentechnisch verbunden. Der Datenspeicher 55 ist mittels einer zweiten Datenverbindung 65 datentechnisch mit dem Datenspeicher 55 verbunden.

In dem Datenspeicher 55 ist beispielhaft ein erster Schwellenwert S1 und vorzugsweise ein zweiter Schwellenwert S2 abgespeichert. Ferner ist in dem Datenspeicher 55 vorzugsweise eine Ersatzschaltung des Feldeffekttransistors 20 abgespeichert. Die Ersatzschaltung ist hierbei typspezifisch für den jeweiligen Feldeffekttransistor 20 und bildet ein elektrisches Verhalten des Feldeffekttransistors 20 bezüglich eines kapazitiven Verhaltens, eines induktiven Verhaltens und eines ohmschen Verhaltens ab. Des Weiteren ist in dem Datenspeicher 55 ein Erstzustand für eine ursprüngliche Gesamtimpedanz Ru des Feldeffekttransistors 20 abgespeichert. Den Erstzustand weist der Feldeffekttransistor 20 in neuem, ursprünglichem Zustand auf.

Mittels einer dritten Datenverbindung 70 kann die Schnittstelle 50 mit einem Fahrzeugsteuergerät 74 des Kraftfahrzeugs datentechnisch verbunden sein. Die dritte Datenverbindung 70 kann beispielsweise auch Teil eines Bussystems, beispielsweise eines CAN-Bus-Systems des Kraftfahrzeugs sein.

Der Feldeffekttransistor 20 weist beispielhaft einen Source-Anschluss 75, einen Gate-Anschluss 80 und einen Drain-Anschluss 85 auf. Der Source-Anschluss 75 ist mittels einer dritten elektrischen Verbindung 90 elektrisch mit dem ersten Anschluss 25 verbunden. Der zweite Anschluss 30 ist mittels einer vierten elektrischen Verbindung 95 elektrisch mit dem Drain-Anschluss 85 verbunden. Der Gate-Anschluss 80 ist mittels einer fünften elektrischen Verbindung 100 mit der Schnittstelle 50 des Steuergeräts 15 elektrisch verbunden.

Ferner ist mittels einer ersten elektrischen Messleitung 105 der Source-Anschluss 75 elektrisch mit der Schnittstelle 50 verbunden. Ferner ist über eine zweite Messleitung 110 die Schnittstelle 50 mit dem Drain-Anschluss 85 elektrisch verbunden. Ferner kann die Schnittstelle 50 über eine dritte Messleitung 115 elektrisch mit dem zweiten Anschluss 30 verbunden sein.

Zusätzlich kann in dem Datenspeicher 55 ein erster ohmscher Leitungswiderstand für die vierte elektrische Verbindung 95 zwischen dem zweiten Anschluss 30 und dem Drain-Anschluss 85 abgelegt sein.

In einem ersten Betriebszustand der elektrischen Schutzeinrichtung 10 ist die elektrische Schutzeinrichtung 10 in einem geschlossenen Zustand geschaltet. Der Feldeffekttransistor 20 kann beispielsweise als Metall-Oxid-Halbleiter-Feldtransistor (MOSFET) ausgebildet sein. So kann der Feldeffekttransistor 20 beispielsweise ein N-Kanal- MOSFET sein. Im ersten Betriebszustand stellt die Steuereinrichtung 45 eine erste Gleichspannung an der Schnittstelle 50 bereit, die über die fünfte elektrische Leitung 100 an dem Gate-Anschluss 80 gegenüber dem Source-Anschluss 75 anliegt. Durch die erste Gleichspannung an dem Gate-Anschluss 80 ist der Feldeffekttransistor 20 geschlossen und der Drain-Anschluss 85 ist mit dem Source-Anschluss 75 elektrisch verbunden. Dadurch kann von der elektrischen Energiequelle 35 über den Feldeffekttransistor 20 elektrische Leistung an den Verbraucher 40 zum Betrieb des Verbrauchers 40 übertragen werden kann.

In einem zweiten Betriebszustand ist der Feldeffekttransistor 20 geöffnet und eine Stromübertragung zwischen dem ersten Anschluss 25 und dem zweiten Anschluss 30 bzw. zwischen der elektrischen Energiequelle 35 und dem elektrischen Verbraucher 40 durch die Schutzeinrichtung 10 unterbrochen. Hierbei stellt die Steuereinrichtung 45 keine oder nur eine geringe (deutlich kleiner als die erste Gleichspannung) elektrische zweite Gleichspannung an der Schnittstelle 50 bereit, die über die fünfte elektrische Verbindung 100 an dem Gate-Anschluss 80 gegenüber dem Source-Anschluss 75 anliegt.

Die Steuereinrichtung 45 schaltet beispielsweise den Feldeffekttransistor 20 in den zweiten Betriebszustand, wenn der Verbraucher 40 eine zu große elektrische Leistung benötigt und beispielsweise ein verdeckter Kurzschluss oder ein offensichtlicher Kurzschluss vorliegt. Auch könnte die Steuereinrichtung 45 den Feldeffekttransistor in den zweiten Betriebszustand schalten, wenn Wartungs- und/oder Reparaturarbeiten am Fahrzeug durchgeführt werden. Die elektrische Schutzeinrichtung 10 wird vom ersten Betriebszustand in den zweiten Betriebszustand beispielsweise geschalten, wenn ein an den Verbraucher 40 fließender Strom einen vordefinierten maximal zulässigen Strom überschreitet.

Über die Lebensdauer der elektrischen Schutzeinrichtung 10 verschlechtert sich ein Transistorzustand (State-of-Health, SoH) des Feldeffekttransistors 20. Da der Feldeffekttransistor 20 in der Schutzeinrichtung 10 eingesetzt ist, um bei einem Überschreiten des zulässigen elektrischen Stroms an den elektrischen Verbraucher 40 den elektrischen Verbraucher 40 zuverlässig von der elektrischen Energiequelle 35 zu trennen, ist ein zuverlässiges Isolierverhalten und ein guter Transistorzustand des Feldeffekttransistors zwingend notwendig.

Ein schlechter werdender Transistorzustand des Feldeffekttransistors 20 zeigt an, dass beispielsweise im Rahmen von Wartungsarbeiten die elektrische Schutzeinrichtung 10 sicherheitshalber zu tauschen ist. Dazu kann in regelmäßigen Abständen oder beispielsweise im Rahmen einer Überprüfung der elektrischen Schutzeinrichtung 10 das im Folgenden beschriebene Verfahren durchgeführt werden.

Figur 2 zeigt ein Ablaufdiagramm des Verfahrens gemäß einer ersten Ausführungsform zur Überprüfung der in Figur 1 gezeigten elektrischen Schutzeinrichtung 10.

In einem ersten Verfahrensschritt 205 schaltet, sofern nicht schon erfolgt, die Steuereinrichtung 45 den Feldeffekttransistor 20 in den offenen, getrennten Zustand. Dazu unterbricht beispielsweise in Figur 1 die Steuereinrichtung 45 die Bereitstellung der ersten Gleichspannung an der fünften elektrischen Verbindung 100, so dass beispielhaft der Gate-Anschluss 80 gegenüber dem Source-Anschluss 75 beispielsweise spannungsfrei geschaltet wird. Dadurch wird die Stromübertragung zwischen der elektrischen Energiequelle 35 und dem elektrischen Verbraucher 40 unterbrochen.

In einem zweiten Verfahrensschritt 210 stellt die Steuereinrichtung 45 an der Schnittstelle 50 ein erstes Prüfsignal bereit. Das erste Prüfsignal liegt zwischen der fünften elektrischen Verbindung 100 und der ersten Messleitung 105 und somit zwischen dem Gate-Anschluss 80 und dem Source-Anschluss 75 an. Das erste Prüfsignal weist eine erste Prüfspannung auf, die eine vordefinierte erste Frequenz f₁ aufweist. Die erste Prüfspannung basiert auf der ersten Gleichspannung und einer der ersten Gleichspannung aufmodulierten ersten Wechselspannung. Das erste Prüfsignal ist derart gewählt, dass die zwischen dem Gate-Anschluss 80 und dem Source-Anschluss 75 anliegende erste Prüfspannung immer positiv oder 0V an dem Gate-Anschluss 80 ist. Die erste Frequenz f₁ kann beispielsweise 5 MHz betragen.

Dadurch dass der Gate-Anschluss 80, sowie der Source-Anschluss 75 und der Drain-Anschluss 85 auch im zweiten Betriebszustand nicht galvanisch voneinander getrennt sind, misst parallel zum zweiten Verfahrensschritt 210 die Steuereinrichtung 45 in einem dritten Verfahrensschritt 215 eine erste Spannung U_{DS} über die zweite und dritte Messleitung 105, 110 zwischen dem Source-Anschluss 75 und dem Gate-Anschluss 80. Zusätzlich bestimmt die Steuereinrichtung 45 einen über die vierte elektrische Verbindung 95 zwischen dem Drain-Anschluss 85 und dem zweiten Anschluss 30 fließenden ersten elektrischen Strom I_{DS}.

Dazu kann beispielsweise die Steuereinrichtung 45 einen Spannungsabfall über die zweite und dritte Messleitung 110, 115 zwischen dem zweiten elektrischen Anschluss 30 und dem Drain-Anschluss 85 ermitteln. Auf Grundlage des im Datenspeicher 55 abgelegten ersten ohmschen Leitungswiderstands für die vierte elektrische Verbindung 95 und des gemessenen Spannungsabfalls zwischen dem zweiten Anschluss 30 und dem Drain-Anschluss 85 bestimmt die Steuereinrichtung 45 den ersten elektrischen Strom I_{DS}.

In Abhängigkeit des Transistorzustands variiert der zwischen dem Drain-Anschluss 85 und dem Source-Anschluss 75 fließende erste elektrische Strom I_{DS}. Ebenso variiert die erste elektrische Spannung U_{DS} in Anhängigkeit des Transistorzustands.

In einem vierten Verfahrensschritt 220 ermittelt die Steuereinrichtung 45 aufgrund des ermittelten ersten elektrischen Strom I_{DS} und der ersten Spannung U_{DS} des ersten Prüfsignals eine Gesamtimpedanz R (R = U_{DS}/I_{DS}).

In einem auf den vierten Verfahrensschritt 220 folgenden fünften Verfahrensschritt 225 ermittelt die Steuereinrichtung 45 auf Grundlage eines Verhältnisses der ermittelten Gesamtimpedanz R zu der im Datenspeicher abgespeicherten ursprünglichen Gesamtimpedanz Ru einen Transistorzustand G des Feldeffekttransistors 20 (G = R/Ru).

In einem auf den fünften Verfahrensschritt 225 folgenden sechsten Verfahrensschritt 230 vergleicht die Steuereinrichtung 45 den ermittelten Transistorzustand G mit dem ersten Schwellenwert S1 und mit dem zweiten Schwellenwert S2. Überschreitet der Transistorzustand G den ersten Schwellenwert S1 und den zweiten Schwellenwert S2, so wird mit einem siebten Verfahrensschritt 235 fortgefahren. Unterschreitet der Transistorzustand G den ersten Schwellenwert S1 und überschreitet der Transistorzustand G den zweiten Schwellenwert S2 so wird mit einem achten Verfahrensschritt 240 fortgefahren. Unterschreitet der Transistorzustand G den ersten Schwellenwert S1 und den zweiten Schwellenwert S2, so wird mit einem neunten Verfahrensschritt 245 fortgefahren.

Im siebten Verfahrensschritt 235 wird mittels eines Informationssignals von der Steuereinrichtung 45 über die Schnittstelle 50 und die dritte Datenverbindung 70 dem Fahrzeugsteuergerät 74 mitgeteilt, dass der Transistorzustand G des Feldeffekttransistors 20 in Ordnung ist und nicht mit einem Ausfall des Feldeffekttransistors 20 zu rechnen ist.

Im achten Verfahrensschritt 240 stellt die Steuereinrichtung 45 über die Schnittstelle 50 ein erstes Warnsignal mit einer ersten Warninformation über die dritte Datenverbindung 70 dem Fahrzeugsteuergerät 74 bereit. Die erste Warninformation weist darauf hin, dass zwar der Feldeffekttransistor 20 noch funktionsfähig ist, jedoch mit einer weiteren Alterung der Feldeffekttransistor 20 beschädigt sein wird und dadurch die elektrische Schutzeinrichtung 10 nicht mehr funktionsfähig sein wird. Die erste Warninformation kann beispielsweise als Fehlercode zum Auslesen an einer ODB-Schnittstelle im Fahrzeugsteuergerät 74 abgespeichert werden.

Im neunten Verfahrensschritt 245 stellt die Steuereinrichtung 45 fest, dass der Feldeffekttransistor 20 beschädigt ist und nicht mehr zuverlässig den Source-Anschluss 75 vom Drain-Anschluss 85 im zweiten Betriebszustand trennt. Aus diesem Grund deaktiviert die Steuereinrichtung 45 eine Ansteuerung des Feldeffekttransistors 20 und stellt über die Schnittstelle 50 ein zweites Warnsignal mit einer zweiten Warninformation bereit. Die zweite Warninformation weist darauf hin, dass der Feldeffekttransistor 20 beschädigt ist und die Schutzeinrichtung 10 zu tauschen ist. Die zweite Warninformation kann beispielsweise als Fehlercode zum Auslesen an der ODB-Schnittstelle im Fahrzeugsteuergerät 74 abgespeichert werden.

Das Verfahren gemäß Figur 2 kann regelmäßig oder anlassbezogen wiederholt werden.

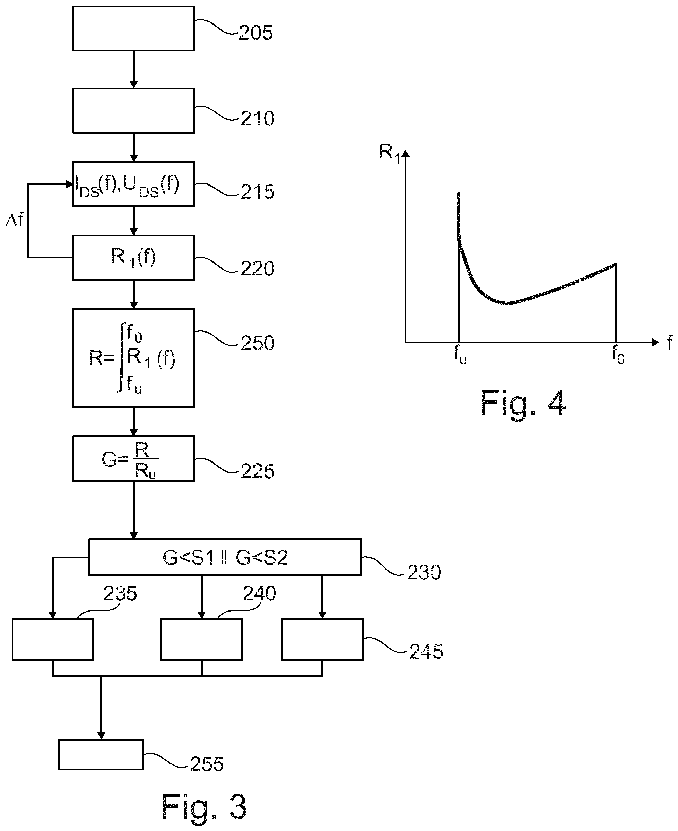

Figur 3 zeigt ein Ablaufdiagramm eines Verfahrens gemäß einer zweiten Ausführungsform zur Überprüfung der in Figur 1 gezeigten elektrischen Schutzeinrichtung 10. Figur 4 zeigt ein Diagramm eines ermittelten Impedanzverlaufs Rₙ des in Figur 1 gezeigten Feldeffekttransistors 20 aufgetragen über der Frequenz f.

Das Verfahren in Figur 3 ist im Wesentlichen identisch zu dem in Figur 2 erläuterten Verfahren ausgebildet. Im Folgenden wird ausschließlich auf die Unterschiede des in Figur 3 erläuterten Verfahrens gegenüber dem in Figur 2 erläuterten Verfahren eingegangen.

Im vierten Verfahrensschritt 220 wird abweichend zu Figur 2 statt der Gesamtimpedanz R eine erste Impedanz R₁(f₁) bei der ersten Frequenz f₁ des ersten Prüfsignals ermittelt und die erste Impedanz R₁(f₁) im Datenspeicher 55 abgespeichert.

Abweichend zu dem im Figur 2 erläuterten Verfahren wird nach erstmaligem Durchlauf des ersten bis vierten Verfahrensschritts 205 bis 220 der zweite Verfahrensschritt 210 wiederholt und in der Wiederholung statt dem ersten Prüfsignal ein zweites Prüfsignal durch die Steuereinrichtung 45 an der Schnittstelle 50 bereitgestellt.

Das zweite Prüfsignal wird über die fünfte elektrische Verbindung 100 und die erste Messleitung 105 an den Feldeffekttransistor 20 übertragen und liegt zwischen dem Source-Anschluss 75 und dem Gate-Anschluss 80 an. Das zweite Prüfsignal ist im Wesentlichen identisch zu dem ersten Prüfsignal, jedoch ist eine zweite Frequenz f₂ des zweiten Prüfsignals unterschiedlich zu der ersten Frequenz f₁ des ersten Prüfsignals. In Figur 3 ist beispielsweise die zweite Frequenz f₂ erhöht gegenüber der ersten Frequenz f₂.

Im dritten Verfahrensschritt 215 wird ein zum zweiten Prüfsignal zugeordneter erster elektrischer Strom I_{DS}(f₂) bei Anliegen des zweiten Prüfsignals mit der zweiten Frequenz f₂ ermittelt, der zwischen dem Drain-Anschluss 85 und dem Source-Anschluss 75 über den Feldeffekttransistor 20 fließt. Ebenso wird eine zum zweiten Prüfsignal zugeordnete erste elektrische Spannung U_{DS}(f₂) ermittelt, die zwischen dem Drain-Anschluss 85 und dem Source-Anschluss 75 bei Anliegen des zweiten Prüfsignals mit der zweiten Frequenz f₂ anliegt.

Im wiederholten vierten Verfahrensschritt 220 wird eine erste Impedanz R₁(f₂) des Feldeffekttransistors 20 bei der zweiten Frequenz f₂ auf Grundlage der ersten elektrischen Spannung U_{DS}(f₂) und des ersten Strom I_{DS}(f₂) bei der zweiten Frequenz f₂ bestimmt.

Der dritte und vierte Verfahrensschritt 215, 220 können jeweils so oft wiederholt werden, bis über ein vordefiniertes Frequenzspektrum zwischen einer unteren Frequenz fu und einer zur unteren Frequenz fu unterschiedlichen zweiten oberen Frequenz f_{O} unterschiedliche Messdaten für die Spannung U_{DS}(f) und den entsprechenden Strom I_{DS}(f) bestimmt sind. Dabei kann die Frequenz f des Prüfsignals jeweils kontinuierlich zwischen der oberen Frequenz f_{O} und der unteren Frequenz fu variierten werden. Auch kann die Frequenz f in vordefinierten Frequenzschritten Δf zwischen der unteren Frequenz fu und der oberen Frequenz f_{O} variiert werden. Die beispielhafte erste und zweite Frequenz f₁, f₂ liegen in dem Intervall zwischen der unteren und oberen Frequenz fu, f_{O} auf Grundlage der zu den unterschiedlichen Frequenzen f ermittelten Impedanzen Rₙ(f).

In einem zusätzlichen zehnten Verfahrensschritt 250, der vorzugsweise zwischen dem vierten Verfahrensschritt 220 und dem fünften Verfahrensschritt 225 durchgeführt wird, wird die Gesamtimpedanz R durch die Steuereinrichtung 45 ermittelt. Dabei integriert beispielsweise die Steuereinrichtung 45 die ermittelten Impedanzen Rₙ(f) über der Frequenz f auf.

Im fünften Verfahrensschritt 225 ermittelt die Steuereinrichtung 45 auf Grundlage der ermittelten Gesamtimpedanz R und der ursprünglich vorliegenden Gesamtimpedanz Ru, die der Feldeffekttransistor 20 bei Auslieferung aufwies, den Transistorzustand G des Feldeffekttransistors 20.

Zusätzlich kann die Steuereinrichtung 45 in einem elften Verfahrensschritt 255 auf Grundlage des ermittelten Impedanzspektrums R(f) der ersten Impedanz R₁ über der Frequenz f und der vordefinierten im Datenspeicher 55 abgelegten Ersatzschaltung einen induktiven Anteil ermitteln. Auf Grundlage des ermittelten induktiven Anteils und eines im Datenspeicher 55 vordefiniert abgelegten induktiven Ursprungsanteils ermittelt die Steuereinrichtung 45 einen induktiven Gesamtzustand. Der induktive Gesamtzustand gibt die Möglichkeit, einen Rückschluss, beispielsweise auf den Zustand der N-Schicht des Feldeffekttransistors 20 zu schließen. Die Steuereinrichtung 45 kann mit einer Information ein zweites Informationssignal über den induktiven Gesamtzustand über die dritte Datenverbindung 70 dem Fahrzeugsteuergerät 74 bereitstellen.

Zusätzlich kann anhand der vordefinierten Ersatzschaltung für den Feldeffekttransistor 20 die Steuereinrichtung 45 aufgrund des ermittelten Impedanzspektrums R₁(f) einen kapazitiven Anteil des Feldeffekttransistors 20 ermitteln. Auf Grundlage des ermittelten kapazitiven Anteils und eines ursprünglich vordefinierten im Datenspeicher abgelegten kapazitiven Ursprungsanteils ermittelt die Steuereinrichtung 45 einen kapazitiven Gesamtzustand des Feldeffekttransistors 20. Der kapazitive Gesamtzustand ermöglicht einen Rückschluss auf einen Transistorzustand, beispielsweise auf einer dielektrischen Isolierung des Feldeffekttransistors zwischen dem Gate-Anschluss 80 und dem Source-Anschluss 75. Dadurch kann eine qualitative Aussage über eine Sicherheit des Feldeffekttransistors 20 auf Grundlage des kapazitiven Gesamtzustands ermittelt werden. Ferner kann die Steuereinrichtung 45 mittels eines dritten Informationssignals über die dritte Datenverbindung 70 dem Fahrzeugsteuergerät 74 eine Information über den kapazitiven Gesamtzustand bereitstellen.

Zusätzlich kann die Steuereinrichtung 45 in dem elften Verfahrensschritt 255 auf Grundlage des ermittelten Impedanzspektrums R₁(f) der Impedanz R über der Frequenz f und der vordefinierten im Datenspeicher 55 abgelegten Ersatzschaltung einen ohmschen Anteil ermitteln. Auf Grundlage des ermittelten ohmschen Anteils und eines im Datenspeicher 55 vordefiniert abgelegten ohmschen Ursprungsanteils ermittelt die Steuereinrichtung 45 einen ohmschen Gesamtzustand. Die Steuereinrichtung 45 kann mittels eines vierten Informationssignals die Information über den ohmschen Gesamtzustand über die dritte Datenverbindung 70 dem Fahrzeugsteuergerät 74 bereitstellen. Mittels des ohmschen Gesamtzustands kann ein Rückschluss auf den Zustand des Feldeffekttransistors 20 geschlossen werden.

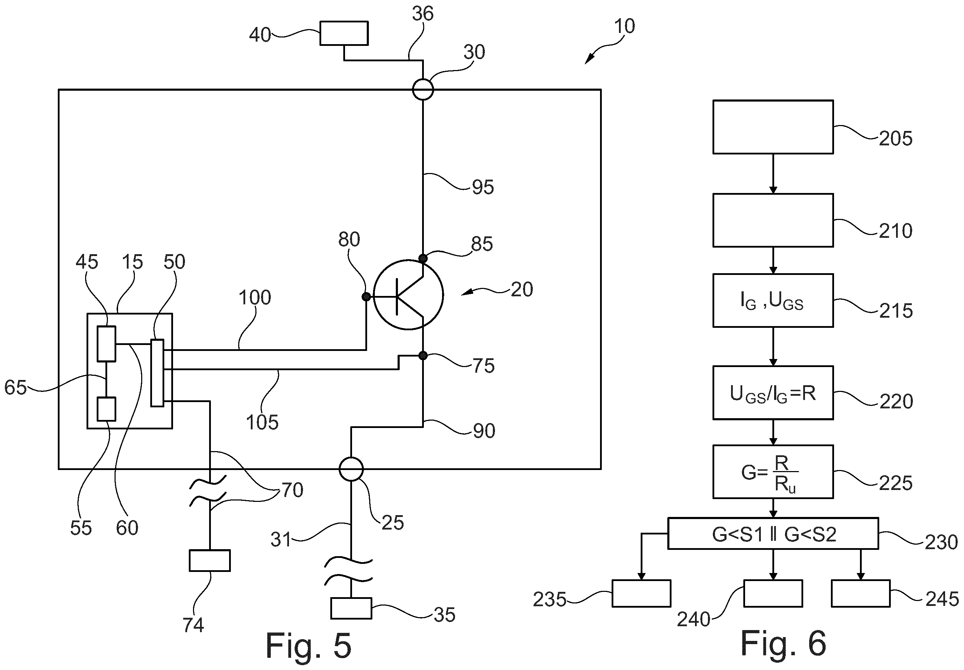

Figur 5 zeigt eine schematische Darstellung einer elektrischen Schutzeinrichtung 10 gemäß einer zweiten Ausführungsform.

Die elektrische Schutzeinrichtung 10 ist im Wesentlichen identisch zu der in Figur 1 gezeigten elektrischen Schutzeinrichtung 10 ausgebildet. Im Folgenden wird ausschließlich auf die Unterschiede der in Figur 5 gezeigten Schutzeinrichtung 10 gegenüber der in Figur 1 gezeigten Schutzeinrichtung 10 eingegangen.

In Figur 5 wird auf die zweite und dritte Messleitung 110, 115 verzichtet. Ferner dient die fünfte elektrische Verbindung 100 ebenso als Messleitung.

Figur 6 zeigt ein Ablaufdiagramm eines Verfahrens gemäß einer dritten Ausführungsform zur Bewertung der in Figur 5 gezeigten elektrischen Schalteinrichtung 10.

Das Verfahren gemäß der dritten Ausführungsform ist im Wesentlichen identisch zu dem in Figur 2 erläuterten Verfahren gemäß der ersten Ausführungsform ausgebildet. Im Folgenden wird ausschließlich auf die Unterschiede des in Figur 6 erläuterten Verfahrens gegenüber dem in Figur 2 erläuterten Verfahren eingegangen.

In dem dritten Verfahrensschritt 215 wird anstatt des ersten Stroms I_{DS} und der ersten Spannung U_{DS} ein zweiter Strom I_{G} und eine zweite Spannung U_{GS} bestimmt. Die zweite Spannung U_{GS} entspricht dabei der Spannung, die das erste Prüfsignal zwischen dem Gate-Anschluss 80 und dem Source-Anschluss 75 aufweist. Der zweite Strom I_{G} ist dabei der elektrische Strom I, der bei Bereitstellung des ersten Prüfsignals über die fünfte elektrische Verbindung 100 von der Schnittstelle 50 zu dem Gate-Anschluss 80 fließt.

Im vierten Verfahrensschritt 220 ermittelt die Steuereinrichtung 45 aufgrund eines zweiten Verhältnisses der zweiten Spannung U_{GS} zu dem zweiten Strom I_{G} die Gesamtimpedanz R.

Im fünften Verfahrensschritt 225 wird der Transistorzustand G aufgrund eines zweiten Verhältnisses der Gesamtimpedanz R zu der ursprünglichen Impedanz Ru durch die Steuereinrichtung 45 ermittelt. Die Steuereinrichtung 45 führt die weiteren Verfahrensschritte 225 bis 245 auf Grundlage des im fünften Verfahrensschritt 225 ermittelten Transistorzustands G durch.

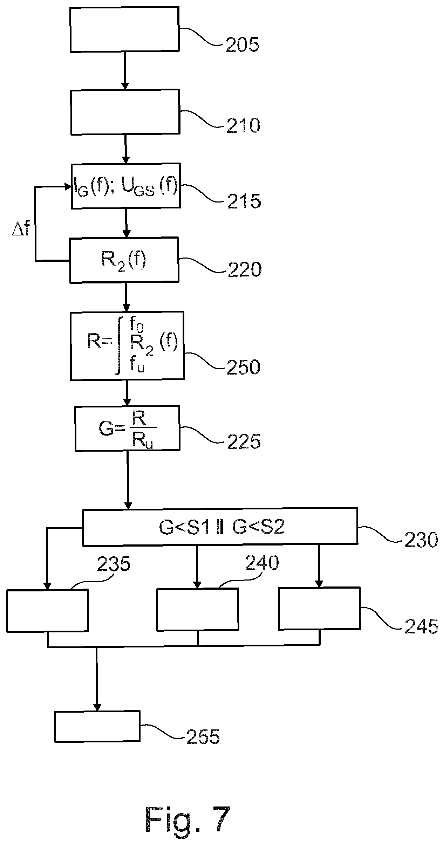

Figur 7 zeigt ein Ablaufdiagramm eines Verfahrens zum Betrieb der in Figur 5 gezeigten elektrischen Schutzeinrichtung 10 gemäß einer vierten Ausführungsform.

Das Verfahren gemäß Figur 7 ist im Wesentlichen eine Kombination aus den in Figur 3 und in Figur 6 beschriebenen Verfahren. Im Folgenden wird ausschließlich auf die Unterschiede des in Figur 7 gezeigten Verfahrens gegenüber dem in Figur 3 beschriebenen Verfahren eingegangen.

Im dritten Verfahrensschritt 215 wird wie auch im dritten Verfahren anstatt der ersten Spannung U_{DS}(f) in Abhängigkeit der Frequenz f und des ersten Stroms I_{DS} (f) in Abhängigkeit der Frequenz f die zweite Spannung U_{GS}(f) und der zweite Strom I_{G}(f), der über die fünfte elektrische Verbindung 100 von der Schnittstelle 50 zu dem Gate-Anschluss 80 fließt, in Abhängigkeit der Frequenz f des Prüfsignals ermittelt. Dabei entspricht die zweite Spannung U_{GS}(f) der Spannung des Prüfsignals, das zwischen der Schnittstelle 50 und der ersten Messleitung 105 angelegt wird.

Im vierten Verfahrensschritt 220 wird statt der ersten Impedanz R₁(f) eine zweite Impedanz R₂(f) in Abhängigkeit der Frequenz f auf Grundlage eines zweiten Verhältnisses der zweiten Spannung U_{GS}(f) zu dem zweiten Strom I_{G}(f) ermittelt.

Im fünften Verfahrensschritt 225 wird der Transistorzustand G auf Grundlage des zweiten Verhältnisses Gesamtimpedanz R (berechnet im zehnten Verfahrensschritt 250) zu der ursprünglichen Impedanz Ru ermittelt.

Im zehnten Verfahrensschritt 250 wird beispielsweise die Gesamtimpedanz R auf Grundlage einer Integration des Impedanzverlaufs der zweiten Impedanz R₂(f) über der Frequenz f von der unteren Frequenz fu bis zur oberen Frequenz f_{O} ermittelt.

Die weiteren Verfahrensschritte werden wie in Figur 3 beschrieben durchgeführt.

Die in Figur 5 gezeigte elektrische Schutzeinrichtung 10 und die beiden zu der Schutzeinrichtung 10 vorgeschlagenen Verfahren gemäß Figur 6 und 7 haben den Vorteil, dass sie besonders einfach sind und die elektrische Schutzeinrichtung 10 besonders einfach ausgebildet ist.

### Bezugszeichenliste

- 10: elektrische Schutzeinrichtung
- 15: Steuergerät
- 20: Feldeffekttransistor
- 25: erster Anschluss
- 30: zweiter Anschluss
- 31: erste elektrische Verbindung
- 35: elektrische Energiequelle
- 36: zweite elektrische Verbindung
- 40: Verbraucher
- 45: Steuereinrichtung
- 50: Schnittstelle
- 55: Datenspeicher
- 60: erste Datenverbindung
- 65: zweite Datenverbindung
- 70: dritte Datenverbindung
- 74: Fahrzeugsteuergerät
- 75: Source-Anschluss
- 80: Gate-Anschluss
- 85: Drain-Anschluss
- 90: dritte elektrische Verbindung
- 95: vierte elektrische Verbindung
- 100: fünfte elektrische Verbindung
- 105: erste Messleitung
- 110: zweite Messleitung
- 115: dritte Messleitung
- 205: erster Verfahrensschritt
- 210: zweiter Verfahrensschritt
- 215: dritter Verfahrensschritt
- 220: vierter Verfahrensschritt
- 225: fünfter Verfahrensschritt
- 230: sechster Verfahrensschritt
- 235: siebter Verfahrensschritt
- 240: achter Verfahrensschritt
- 245: neunter Verfahrensschritt
- 250: zehnter Verfahrensschritt
- 255: elfter Verfahrensschritt
- Δf: Frequenzschritt
- f: Frequenz
- f1: erste Frequenz
- f2: zweite Frequenz
- fU: untere Frequenz
- fO: obere Frequenz
- G: Transistorzustand
- I: elektrischer Strom
- IDS: erster elektrischer Strom
- IG: zweiter elektrischer Strom
- R: Gesamtimpedanz
- R(f): Impedanzspektrum
- R1: erste Impedanz
- R2: zweite Impedanz
- RI: ermittelte Impedanz
- Rn: ermittelte Impedanz
- RU: ursprüngliche Gesamtimpedanz
- S1: erster Schwellenwert
- S2: zweiter Schwellenwert
- UDS: erste elektrische Spannung
- UGS: zweite elektrische Spannung

## Patentansprüche

1. Verfahren zum Betrieb einer elektrischen Schutzeinrichtung (10) mit einem Feldeffekttransistor (20) zur elektrischen Absicherung eines elektrischen Verbrauchers (40), vorzugsweise in einem Kraftfahrzeug,
- wobei der Feldeffekttransistor (20) einen Gate-Anschluss (80), einen Source-Anschluss (75) und einen Drain-Anschluss (85) aufweist,
- wobei wenigstens ein Prüfsignal mit wenigstens einer vordefinierten Prüfspannung und mit wenigstens einer vordefinierten ersten Prüffrequenz zwischen dem Gate-Anschluss (80) des Feldeffekttransistors (20) und dem Source-Anschluss (75) angelegt wird,
- wobei wenigstens ein über einen der Anschlüsse (75, 80, 85) auf Grundlage des Prüfsignals fließender Strom (I_{DS}, I_{G}) ermittelt wird,
- wobei eine Spannung (U_{DS}, U_{GS}) zwischen dem Source-Anschluss (75) und dem Drain-Anschluss (85) und/oder zwischen dem Source-Anschluss (75) und dem Gate-Anschluss (80) ermittelt wird,
- wobei auf Grundlage der ermittelten Spannung (U_{DS}, U_{GS}) und des ermittelten Stroms (I_{DS}, I_{G}) eine Gesamtimpedanz (R) des Feldeffekttransistors (20) ermittelt wird,
- wobei auf Grundlage einer ursprünglichen Impedanz (Ru) des Feldeffekttransistors (20) und der ermittelten Gesamtimpedanz (R) ein Transistorzustand (G) des Feldeffekttransistors (20) ermittelt wird.

2. Verfahren nach Anspruch 1,
- wobei der ermittelte Transistorzustand (G) mit einem vordefinierten ersten Schwellenwert (S1) verglichen wird,
- wobei bei Überschreiten des ersten Schwellenwerts (S1) eine Warninformation ausgeben wird.

3. Verfahren nach Anspruch 2,
- wobei der ermittelte Transistorzustand (G) mit einem zweiten Schwellenwert (S2) verglichen wird,
- wobei der zweite Schwellenwert (S2) größer als der erste Schwellenwert (S1) ist,
- wobei bei einem Überschreiten des zweiten Schwellenwerts (S2) durch den ermittelten Transistorzustand (G) eine Übertragung von elektrischer Leistung zwischen dem Drain-Anschluss (85) und dem Source-Anschluss (75) dauerhaft unterbrochen wird.

4. Verfahren nach einem der vorhergehenden Ansprüche,
- wobei zur Ermittlung eines Impedanzspektrums (R₁(f), R₂(f)) des Feldeffekttransistors (20) das Prüfsignal zwischen der ersten Prüffrequenz und einer zur ersten Prüffrequenz unterschiedlichen zweiten Prüffrequenz variiert wird,
- wobei jeweils der auf Grundlage des Prüfsignals fließende elektrische Strom (I_{GS}(f), I_{G}(f)) und die elektrische Spannung (U_{DS}(f), U_{GS} (f)) zwischen dem Source-Anschluss (75) und dem Drain-Anschluss (85) und/oder zwischen dem Source-Anschluss (75) und dem Gate-Anschluss (80) ermittelt werden,
- wobei zu jeweils der Prüffrequenz des Prüfsignals auf Grundlage des ermittelten elektrischen Stroms (I_{DS}(f), I_{G}(f)) und der ermittelten Spannung (U_{DS}(f), U_{GS} (f)) jeweils eine Impedanz (R₁(f), R₂(f)) zur Ermittlung des Impedanzspektrums (R₁(f), R₂(f)) ermittelt werden,
- wobei auf Grundlage des ermittelten Impedanzspektrums (R₁(f), R₂(f)) die Gesamtimpedanz (R) ermittelt wird.

5. Verfahren nach Anspruch 4,
- wobei die Gesamtimpedanz (R) durch Integration eines Verlaufs der Impedanz (R₁(f), R₂(f)) über die Prüffrequenz (f) zwischen der ersten Prüffrequenz (fu) und der zweiten Prüffrequenz (fo) ermittelt wird.

6. Verfahren nach Anspruch 4 oder 5,
- wobei auf Grundlage einer vordefinierten Ersatzschaltung des Feldeffekttransistors (20) und des Impedanzspektrums (R₁(f), R₂(f)) ein induktiver Anteil des Feldeffekttransistors (20) ermittelt wird,
- wobei auf Grundlage des ermittelten induktiven Anteils und eines vordefinierten induktiven ursprünglichen Anteils ein induktiver Gesamtzustand des Feldeffekttransistors (20) ermittelt wird.

7. Verfahren nach einem der vorhergehenden Ansprüche,
- wobei auf Grundlage einer vordefinierten Ersatzschaltung des Feldeffekttransistors (20) und des ermittelten Impedanzspektrums (R₁(f), R₂(f)) ein kapazitiver Anteil des Feldeffekttransistors (20) ermittelt wird,
- wobei auf Grundlage des ermittelten kapazitiven Anteils und eines vordefinierten kapazitiven ursprünglichen Anteils ein kapazitiver Gesamtzustand des Feldeffekttransistors (20) ermittelt wird.

8. Verfahren nach einem der vorhergehenden Ansprüche,
- wobei auf Grundlage einer vordefinierten Ersatzschaltung des Feldeffekttransistors (20) und des ermittelten Impedanzspektrums (R₁(f), R₂(f)) ein ohmscher Anteil des Feldeffekttransistors (20) ermittelt wird,
- wobei auf Grundlage des ermittelten ohmschen Anteils und eines vordefinierten ohmschen ursprünglichen Anteils ein ohmscher Gesamtzustand ermittelt wird.

9. Verfahren nach einem der vorhergehenden Ansprüche,
- wobei der Strom (I_{G}), der zu dem Gate-Anschluss (80) des Feldeffekttransistor (20) fließt, ermittelt wird,
- wobei die Spannung (U_{GS}) zwischen dem Source-Anschluss (75) und dem Gate-Anschluss (80) ermittelt wird.

10. Verfahren nach einem der vorhergehenden Ansprüche,
- wobei der Strom (I_{DS}), der zwischen dem Drain-Anschluss (80) und dem Source-Anschluss (75) fließt, ermittelt wird,
- wobei die Spannung (U_{DS}) zwischen dem Source-Anschluss (75) und Drain-Anschluss (85) ermittelt wird.

11. Elektrische Schutzeinrichtung (10) zur elektrischen Absicherung eines Verbrauchers gegenüber einer elektrischen Stromquelle,
- wobei die elektrische Schutzeinrichtung (10) ausgebildet ist, das Verfahren gemäß einem der vorhergehenden Ansprüche durchzuführen.
